# EUROPÄISCHE PATENTSCHRIFT

(11) **EP 2 741 407 B1**
(45) Veröffentlichungstag und Bekanntmachung des Hinweises auf die Patenterteilung: **10.03.2021**
(21) Anmeldenummer: 13188035.3
(22) Anmeldetag: 10.10.2013
(51) Int. Cl.: H02M 1/32, H02M 7/5387, G01R 31/40, H03K 17/16, H03K 17/78, H02M 1/08

(54) **Leistungselektronische Schaltung, elektrische Maschine und Verfahren zum Überprüfen der Funktionsfähigkeit einer leistungselektronischen Schaltung**
Power electronics circuit, electric machine and method for monitoring the functionality of a power electronics circuit
Circuit électronique de puissance, machine électrique et procédé de contrôle de la fonctionnalité d'un circuit électronique de puissance

(30) Priorität: 23.10.2012 DE 102012219320
(43) Veröffentlichungstag der Anmeldung: 11.06.2014
(73) Patentinhaber: KUKA Deutschland GmbH, 86165 Augsburg (DE)
(72) Erfinder: Zehetbauer, Sebastian, 81673 München (DE); Langhans, Michael, 86483 Balzhausen (DE)
(74) Vertreter: Schlotter, Alexander Carolus Paul

(56) Entgegenhaltungen:
- CN-U- 202 309 677
- DE-A1- 10 307 999
- KR-A- 20120 112 333
- US-A1- 2006 109 034
- US-A1- 2010 097 121
- Wolfgang reinhold, Günther Koss, Friedrich Hoppe: "Lehr- und Übungsbuch Elektronik", 1 April 1998 (1998-04-01), FAchbuchverlag Leipzig, Germany ISBN: 3-446-40016-8 pages 74-75, * page 75 *

## Beschreibung

Die Erfindung betrifft eine leistungselektronische Schaltung eine elektrische Maschine mit der leistungselektronischen Schaltung und ein Verfahren zum Überprüfen der Funktionsfähigkeit der leistungselektronischen Schaltung.

Die DE 100 59 173 C1 offenbart eine Antriebssteuerung für einen Drehstrommotor über einen Wechselrichter in sicherer Technik. Die Leistungstransistoren des Wechselrichters werden mittels Mittel zur Impulssperre angesteuert. Im Fehlerfall werden die jeweiligen Leistungstransistoren des Wechselrichters mittels der Mittel zur Impulssperre gesperrt, indem jeweilige Versorgungsspannungen für die Ansteuerung der Leistungstransistoren unterbrochen werden. Die Funktionsfähigkeit der Mittel zur Impulssperre wird zyklisch überprüft, z.B. nach jedem Einschalten der Versorgungsspannung.

Weitere Beispiele von Treiberschaltungen sind aus KR20120112333 und CN202309677U bekannt.

Aufgabe der Erfindung ist es, eine Möglichkeit zu schaffen, die Funktionstüchtigkeit einer Ansteuerelektronik einer leistungselektronischen Schaltung im laufenden Betrieb der leistungselektronischen Schaltung zu überprüfen.

Die Aufgabe der Erfindung wird gelöst durch eine leistungselektronische Schaltung nach dem unabhängigen Anspruch 1. Ein weiterer Aspekt der Erfindung betrifft eine elektrische Maschine, aufweisend die erfindungsgemäße leistungselektronische Schaltung, einen elektrischen Verbraucher, welcher mittels der leistungselektronischen Schaltung mit der getakteten elektrischen Spannung versorgt wird, und eine Steuervorrichtung, welche eingerichtet ist, den ersten Halbleiterschalter gemäß dem Pulsmuster durch Ansteuern zu öffnen und zu schließen.

Die erfindungsgemäße leistungselektronische Schaltung ist z.B. ein getaktetes Netzteil, d.h. ein Netzteil, das eine getaktete elektrische Spannung für einen elektrischen Verbraucher erzeugt. Dies wird mittels des Leistungshalbleiterschalters erreicht, der abwechselnd ein und ausgeschaltet wird. Als Leistungshalbleiterschalter kann z.B. ein Leistungstransistor verwendet werden, wie dies dem Fachmann im Prinzip bekannt ist. Der Leistungstransistor ist z.B. ein FET bzw. ein MOSFET Transistor. Ein Beispiel eines getakteten Netzteils ist ein Wechselrichter, der aus einer Gleichspannung eine Wechselspannung erzeugt. Wechselrichter sind insbesondere vorgesehen, eine dreiphasige Wechselspannung aus der Gleichspannung zu erzeugen und weisen mehrere Leistungshalbleiterschalter auf, die z.B. mittels Pulsweitenmodulation abwechselnd geöffnet und geschlossen werden, um z.B. einen Drehstrommotor als elektrischen Verbraucher anzutreiben.

Die erfindungsgemäße elektrische Maschine ist beispielsweise ein Roboter, insbesondere ein Industrieroboter. Roboter umfassen in der Regel einen Roboterarm und eine Steuervorrichtung. Der Roboterarm weist mehrere, hintereinander angeordnete und über Gelenke verbundene Glieder und elektrische Motoren zum Bewegen der Glieder relativ zueinander auf. Die elektrischen Motoren werden in der Regel mittels Wechselrichter als Leistungsteil angesteuert. Ein solcher erfindungsgemäßer Roboter umfasst demnach wenigstens einen Wechselrichter, dessen Leistungshalbleiterschalter mittels einer oder mehrerer Ansteuerelektroniken gemäß der erfindungsgemäßen leistungselektronischen Schaltung angesteuert werden. Die Steuervorrichtung, auf der vorzugsweise auch ein Steuerprogramm zum Bewegen der einzelnen Glieder des Roboterarms läuft, ist eingerichtet, die Ansteuerelektronik oder Ansteuerelektroniken bzw. deren ersten Halbleiterschalter anzusteuern.

Um den wenigstens einen Leistungshalbleiterschalter zu öffnen und zu schließen, weist die erfindungsgemäße leistungselektronische Schaltung die Ansteuerelektronik auf, welche den wenigstens einen Leistungshalbleiterschalter gemäß dem Pulsmuster ansteuert. Insbesondere für eine galvanische Trennung umfasst die Ansteuerelektronik den Optokoppler, welcher wiederum als Eingangsstufe den Lichtsender und als Ausgangsstufe den Lichtempfänger aufweist. Der Lichtsender umfasst z.B. eine Leuchtdiode und ist eingerichtet, Licht zu erzeugen, wenn durch den Lichtsender ein elektrischer Strom fließt bzw. am Lichtsender eine elektrische Spannung anliegt. Der Lichtsender und der Lichtempfänger sind derart optisch gekoppelt, dass der Lichtempfänger das vom Lichtsender erzeugte Licht empfängt und daraufhin ein entsprechendes elektrisches Signal, z.B. in Form eines elektrischen Stroms oder einer elektrischen Spannung, erzeugt. Dieses elektrische Signal ist das Ansteuersignal für den Leistungshalbleiterschalter. Der Lichtempfänger umfasst z.B. eine Fotodiode mit nachgeschalteter Treiberstufe, kann aber z.B. auch einen Fototransistor, einen Fotothyristor, einen Fototriac, einen Foto-Schmitt-Trigger oder einen Fotodarlingtontransistor umfassen.

Parallel zum Optokoppler bzw. zu dessen Lichtsender ist der erste Halbleiterschalter geschaltet. Der erste Halbleiterschalter ist z.B. als ein erster Transistor ausgeführt. Der erste Transistor ist vorzugsweise ein erster bipolarer Transistor. Liegt nun an dieser Parallelschaltung eine elektrische Versorgungsspannung an, dann kann durch Ein- und Ausschalten des ersten Halbleiterschalters der Fluss des elektrischen Stroms durch den Lichtsender des Optokopplers gesteuert werden und zwar dadurch, dass bei geöffnetem ersten Halbleiterschalter der elektrische Strom durch den Lichtsender fließt, dieser dann Licht erzeugt und somit die Ausgangsstufe des Optokopplers den Leitungshableiterschalter schließt. Ist der erste Halbleiterschalter dagegen geschlossen, dann ist der Eingang des Optokopplers bzw. der Lichtsender kurz geschlossen und erzeugt kein Licht. Dadurch steuert der Optokoppler bzw. die Ansteuerelektronik z.B. den Leistungshalbleiterschalter derart an, dass dieser geöffnet ist.

Die Ansteuerelektronik der erfindungsgemäßen leistungselektronischen Schaltung umfasst ferner den zweiten Halbleiterschalter. Dieser ist z.B. als ein zweiter Transistor, vorzugsweise als ein zweiter bipolarer Transistor ausgeführt und ist in Serie zur Parallelschaltung aus dem Optokoppler bzw. dessen Lichtsender und dem ersten Halbleiterschalter geschaltet.

Der zweite Halbleiterschalter ist insbesondere vorgesehen, das Leistungsteil abzuschalten. Im Normalbetrieb ist es insbesondere vorgesehen, den zweiten Halbleiterschalter geschlossen zu lassen und zum schnellen Abschalten den zweiten Halbleiterschalter zu öffnen. Bei geschlossenem zweiten Halbleiterschalter, also im Normalbetrieb, fließt daher unabhängig vom Schaltzustand des ersten Halbleiterschalters ein elektrischer Strom durch den zweiten Halbleiterschalter. Bei geöffnetem zweiten Halbleiterschalter fließt unabhängig vom Schaltzustand des ersten Halbleiterschalters kein elektrischer Strom durch den Lichtsender des Optokopplers, wodurch die Ansteuerelektronik den Leistungshalbleiterschalter derart ansteuert, sodass dieser geöffnet ist.

Dadurch ist es möglich, wie dies bei der erfindungsgemäßen leistungselektronischen Schaltung vorgesehen ist, dass diese eingerichtet ist, während eines Normalbetriebs den ersten Halbleiterschalter gemäß dem Pulsmuster abwechselnd zu öffnen und zu schließen und den zweiten Halbleiterschalter geschlossen zu lassen, und während eines Testbetriebs den ersten Halbleiterschalter gemäß dem Pulsmuster abwechselnd zu öffnen und zu schließen und den zweiten Halbleiterschalter zu einem Zeitpunkt, an dem der wenigstens eine Leistungshalbleiterschalter geöffnet ist, zu öffnen und wieder zu schließen, bevor der Leistungshalbleiterschalter wieder geschlossen werden soll. Dadurch ist es auch nach einer Variante der erfindungsgemäßen elektrischen

Maschine möglich, dass deren Steuervorrichtung eingerichtet ist, während eines Normalbetriebs den ersten Halbleiterschalter gemäß dem Pulsmuster abwechselnd zu öffnen und zu schließen und den zweiten Halbleiterschalter geschlossen zu lassen, und während eines Testbetriebs den ersten Halbleiterschalter gemäß dem Pulsmuster abwechselnd zu öffnen und zu schließen und den zweiten Halbleiterschalter zu einem Zeitpunkt, in der der wenigstens eine Leistungshalbleiterschalter geöffnet ist, zu öffnen und wieder zu schließen, bevor der Leistungshalbleiterschalter wieder geschlossen werden soll. Dadurch ist es möglich die Funktionstüchtigkeit des zweiten Halbleiterschalters auch im laufenden Betrieb der leistungselektronische Schaltung bzw. der elektrischen Maschine zu Testzwecken zu öffnen ohne den laufenden Betrieb zu stören bzw. diesen wesentlich zu beeinträchtigen.

Ein weiterer Aspekt der Erfindung betrifft somit ein Verfahren zum Testen der erfindungsgemäßen leistungselektronischen Schaltung bzw. der leistungselektronischen Schaltung der erfindungsgemäßen elektrischen Maschine nach dem Anspruch 7

Um die Funktionstüchtigkeit des zweiten Halbleiterschalters zu überprüfen, kann es vorgesehen sein, während des Testbetriebs das am zweiten Halbleiterschalter anliegende elektrische Signal auszuwerten, um zu Überprüfen, dass der zweite Halbleiterschalter zuverlässig öffnet. Das elektrische Signal ist z.B. die am zweiten Halbleiterschalter anliegende elektrische Spannung oder der durch den zweiten Halbleiterschalter fließende elektrische Strom. Wird der elektrische Strom als elektrisches Signal verwendet, dann wird z.B. auf einen defekten zweiten Halbleiterschalter geschlossen, wenn der Betrag des durch den zweiten Halbleiterschalter fließenden elektrischen Stroms einen vorgegeben Mindestwert überschreitet, obwohl der zweite Halbleiterschalter geöffnet sein soll. Andernfalls ist der zweite Halbleiterschalter in Ordnung.

Es kann auch vorgesehen sein, dass der zweite Halbleiterschalter verwendet wird, eine Sperrung oder Freigabe des Wechselrichters bzw. des Leistungsteils zu anderen Zwecken umzusetzen. Beispielsweise kann es vorgesehen sein, dass das Signal zum Ansteuern des ersten Halbleiterschalters von einem programmierbaren Baustein bereitgestellt wird, der eine gewisse Zeit zur Initialisierung benötigt und währenddessen noch keine definierten Steuersignale für den ersten Halbleiterschalter bereitstellen kann. Die Steuervorrichtung der erfindungsgemäßen elektrischen Maschine kann eingerichtet sein, während eines Initialisierens der leistungselektronischen Schaltung den zweiten Halbleiterschalter geöffnet zu lassen.

Ein Ausführungsbeispiel der Erfindung ist exemplarisch in den beigefügten schematischen Zeichnungen dargestellt. Es zeigen:
- Fig. 1: einen Roboter mit einem Roboterarm,
- Fig. 2: teilweise einen Schaltplan eines elektrischen Antriebs zum Bewegen eines der Glieder des Roboterarms und
- Fig. 3: einen Schaltplan einer Ansteuerelektronik des elektrischen Antriebs.

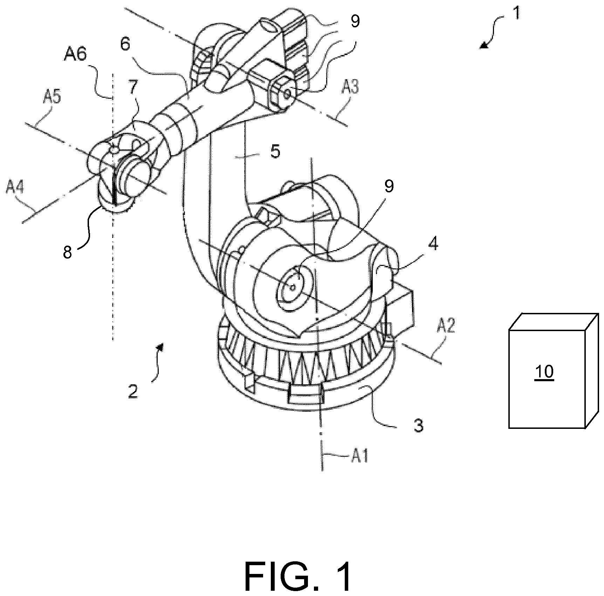

Die Fig. 1 zeigt einen Roboter 1 mit einem Roboterarm 2 in einer perspektivischen Darstellung.

Der Roboterarm 2 umfasst im Falle des vorliegenden Ausführungsbeispiels mehrere, nacheinander angeordnete und mittels Gelenke verbundene Glieder. Bei den Gliedern handelt es sich insbesondere um ein ortsfestes oder bewegliches Gestell 3 und ein relativ zum Gestell 3 um eine vertikal verlaufende Achse A1 drehbar gelagertes Karussell 4. Weitere Glieder des Roboterarms 2 sind im Falle des vorliegenden Ausführungsbeispiels eine Schwinge 5, ein Ausleger 6 und eine vorzugsweise mehrachsige Roboterhand 7 mit einer z.B. als Flansch 8 ausgeführten Befestigungsvorrichtung zum Befestigen eines nicht näher dargestellten Endeffektors. Die Schwinge 5 ist am unteren Ende z.B. an einem nicht näher dargestellten Schwingenlagerkopf auf dem Karussell 4 um eine vorzugsweise horizontale Achse A2 schwenkbar gelagert. Am oberen Ende der Schwinge 5 ist wiederum um eine ebenfalls vorzugsweise horizontale Achse A3 der Ausleger 6 schwenkbar gelagert. Dieser trägt endseitig die Roboterhand 7 mit ihren vorzugsweise drei Achsen A4, A5, A6.

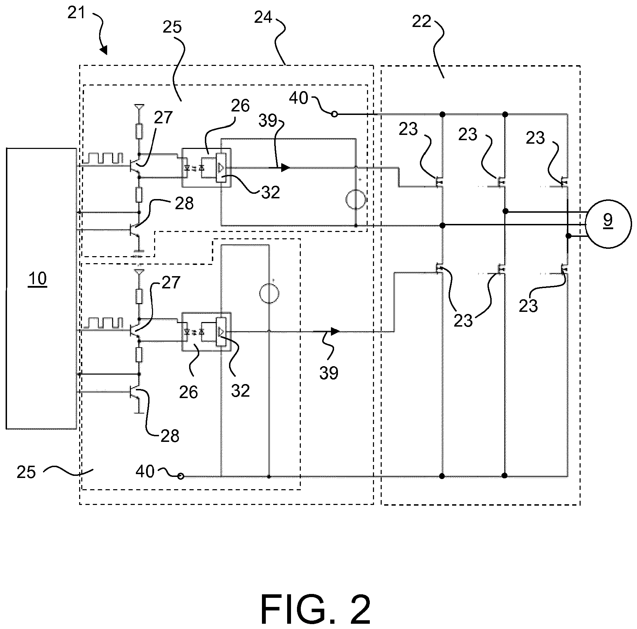

Um den Roboter 1 bzw. dessen Roboterarm 2 zu bewegen, umfasst dieser in allgemein bekannter Weise mit einer Steuervorrichtung 10 verbundene elektrische Antriebe 21. Ein Schaltplan einer dieser elektrischen Antriebe 21 ist in der Fig. 2 teilweise dargestellt. In der Figur 1 sind nur einige der elektrischen Motoren 9 dieser elektrischen Antriebe 21 gezeigt, welche im oder am Roboterarm 2 befestigt sind. Leistungselektroniken der elektrischen Antriebe 21 sind z.B. innerhalb eines Gehäuses eines nicht näher dargestellten Steuerschranks angeordnet, innerhalb dem z.B. auch die Steuervorrichtung 10 angeordnet ist. Die elektrischen Motoren 9 sind im Falle des vorliegenden Ausführungsbeispiels Drehstrommotoren, beispielsweise Drehstrom-Synchronmotoren. Die Leistungselektroniken der elektrischen Antriebe können auch im und/oder am Roboterarm 2 angeordnet sein.

Die Leistungselektroniken umfassen im Falle des vorliegenden Ausführungsbeispiels, wie dies dem Fachmann im Prinzip bekannt ist, einen nicht näher dargestellten Gleichrichter, welcher aus der Netzspannung eine Gleichspannung erzeugt, einen dem Gleichrichter nachgeschalteten, ebenfalls nicht näher dargestellten Zwischenkreis mit einem Zwischenkreiskondensator zum Glätten der Gleichspannung und mehrere, dem Zwischenkreiskondensator nachgeschaltete Umrichter bzw. Wechselrichter 22. Die geglättete Gleichspannung ist die Versorgungsspannung der Wechselrichter 22 und liegt z.B. an den Knoten 40 an. Von den Wechselrichtern 22 ist jeweils einer einem der elektrischen Motoren 9 vorgeschaltet, sodass die Wechselrichter 22 ihre Motoren 9 mit geeigneten elektrischen dreiphasigen Spannungen versorgen, wie dies dem Fachmann im Prinzip bekannt ist.

Auf der Steuervorrichtung 10, welche z.B. als ein Computer ausgeführt ist, läuft ein Rechenprogramm, mittels dem die Steuervorrichtung 10 im Betrieb des Roboters 1 diesen beispielsweise derart ansteuert, dass der Flansch 8 oder ein sogenannter Tool Center Point eine vorbestimmte Bewegung ausführt. Gegebenfalls regelt die Steuervorrichtung 10 die elektrischen Antriebe 21, wie dies im Prinzip dem Fachmann bekannt ist. Gegebenfalls sind die elektrischen Antriebe 21 geregelte elektrische Antriebe und die Steuervorrichtung 10 erzeugt Soll-Signale für die geregelten elektrischen Antriebe bzw. deren Wechselrichter 22.

Im Falle des vorliegenden Ausführungsbeispiels umfassen die Wechselrichter 22 beispielsweise jeweils sechs Leistungshalbleiterschalter, welche z.B. als Leistungstransistoren 23 ausgeführt sind. Die Leistungstransistoren 23 sind insbesondere in FET Technologie ausgeführt, können aber auch andere Transistoren oder Leistungshalbleiterschalter sein. Die Wechselrichter 22 umfassen insbesondere drei Halbbrücken.

Im Betrieb des Roboters 1 werden die Wechselrichter 22 bzw. deren Leistungstransistoren 23 derart angesteuert, sodass diese eine der jeweiligen Anwendung entsprechende dreiphasige Spannung erzeugen, mit der der entsprechende elektrische Motor 9 beaufschlagt wird. Dazu werden die Wechselrichter 22 bzw. deren Leistungstransistoren 23, insbesondere die Gates der Leistungstransistoren 23 mittels einer Steuerschaltung 24 und unter Verwendung der dem Fachmann im Prinzip bekannten Pulsweitenmodulation angesteuert. Bei dem Wechselrichter 22 inklusive Steuerschaltung 24 handelt es sich demnach im Wesentlichen um eine leistungselektronische Schaltung, insbesondere um ein getaktetes Netzteil.

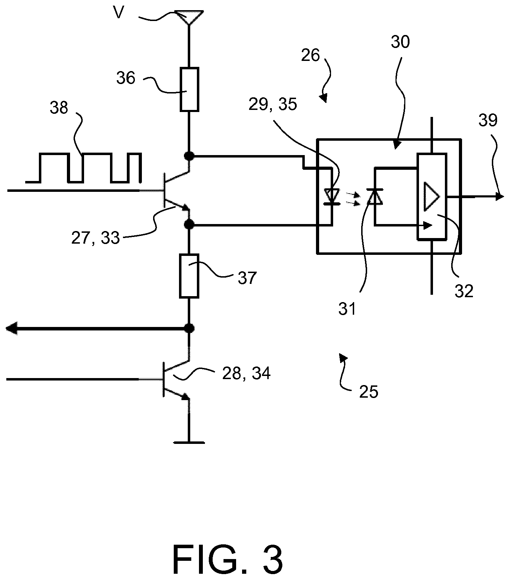

Im Falle des vorliegenden Ausführungsbeispiels umfasst die Steuerschaltung 24 mehrere Ansteuerelektroniken 25, von denen jeweils eine einem der Leistungstransistoren 23 zugeordnet ist. Die jeweiligen Ansteuerelektroniken 25 sind vorgesehen, den ihnen zugeordneten Leistungstransistor 23 anzusteuern. In der Fig. 2 sind der Übersicht wegen nur zwei der Ansteuerelektroniken 25 gezeigt, welcher einer der Halbbrücken des dargestellten Wechselrichters 22 zugeordnet sind. Eine der Ansteuerelektroniken 25 ist in der Fig. 3 näher dargestellt.

Im Falle des vorliegenden Ausführungsbeispiels umfasst jede der Ansteuerelektroniken 25 einen Optokoppler 26 und einen ersten Halbleiterschalter 27 und einen zweiten Halbleiterschalter 28. Die beiden Halbleiterschalter 27, 28 sind insbesondere als erster Transistor 33 und als zweiter Transistor 34 ausgeführt. Die beiden Transistoren 33, 34 sind beispielsweise bipolare Transistoren.

Der Optokoppler 26 umfasst im Falle des vorliegenden Ausführungsbeispiels eine als einen Lichtsender 29 ausgeführte Eingangsstufe, welche Licht emittiert, wenn am Eingang des Optokoplers 26 eine elektrische Spannung anliegt. Der Lichtsender 29 ist insbesondere als Leuchtdiode 35 ausgeführt. Als Ausgangsstufe umfasst der Optokoppler 26 einen Lichtempfänger 30, welcher das von dem Lichtsender 29 bzw. der Fotodiode 35 emittierte Licht in ein elektrisches Signal umwandelt, welches als Ansteuersignal 39 für den der entsprechenden Ansteuerelektronik 25 zugeordneten Leistungstransistor 23 dient. Im Falle des vorliegenden Ausführungsbeispiels weist die Ausgangsstufe bzw. der Lichtempfänger 30 eine mit dem Lichtsender 29 bzw. der Leuchtdiode 35 gekoppelte Fotodiode 31 und eine der Fotodiode 31 nachgeschaltete Treiberstufe 32 auf. Der Ausgang der Treiberstufe 32 ist mit dem Gate des entsprechenden Leistungstransistors 23 verbunden. Der Lichtempfänger 30 kann aber z.B. auch einen Fototransistor, einen Fotothyristor, einen Fototriac, einen Foto-Schmitt-Trigger oder einen Fotodarlingtontransistor umfassen.

Im Falle des vorliegenden Ausführungsbeispiels ist der erste Halbleiterschalter 27 bzw. der erste Transistor 33 der Ansteuerelektronik 25 derart parallel zur Eingangsstufe bzw. zum Lichtsender 29 geschaltet, dass bei geschlossenem ersten Halbleiterschalter 27 der Eingang des Optokopplers 26 bzw. dessen Lichtsender 29 elektrisch kurzgeschlossen ist. Wenn es sich bei dem ersten Halbleiterschalter 27 um einen bipolaren ersten Transistor 33 handelt, dann sind insbesondere der Kollektor und der Emitter des ersten Transistors 33 mit dem Lichtsender 29 bzw. der Leuchtdiode 35 des Optokopplers 26 verbunden und der erste Transistor 33 wird durch Ansteuern seiner Basis ein bzw. ausgeschaltet.

Im Falle des vorliegenden Ausführungsbeispiels ist der zweite Halbleiterschalter 28 bzw. der zweite Transistor 34 der Ansteuerelektronik 25 in Serie zur Parallelschaltung aus dem Optokoppler 26 und dem ersten Halbleiterschalter 27 geschaltet.

Im Betrieb des Roboters liegen an den Ansteuerelektroniken 25 eine elektrische Spannung bzw. Versorgungsspannung V an, insbesondere an der Serienschaltung, aufweisend den zweiten Halbleiterschalter 28 und der Parallelschaltungen aus dem Optokoppler 26 und dem ersten Halbleiterschalter 27.

Im Normalbetrieb sind die zweiten Halbleiterschalter 28 geschlossen bzw. sind die zweiten Transistoren 34 leitend und die ersten Halbleiterschalter 27 werden mittels Pulsweitenmodulation geöffnet und geschlossen, sodass die Leistungstransistoren 23 entsprechend der gewählten Pulsweitenmodulation angesteuert werden.

Über die an den Basen der ersten Transistoren 33 anliegenden Pulsmuster 38 der Pulsweitenmodulation steuern die Optokoppler 26 die Leistungstransistoren 23 an. Im Falle des vorliegenden Ausführungsbeispiels repräsentieren die Pulsmuster 38 an den Basen der ersten Transistoren 27 das invertierte Pulsmuster für die Ausgangsstufen 30 der Optokoppler (Ausgangssignal 39 des Optokopplers 26), da bei geöffneten ersten Halbleiterschaltern 27 an dem Lichtsender 29 des entsprechenden Optokopplers 26 die elektrische Spannung anliegt und somit die Optokoppler 26 bei geöffneten ersten Halbleiterschaltern 27 die Leistungstransistoren 23 einschalten. Ist dagegen der entsprechende erste Halbleiterschalter 27 geschlossen, dann wird der Lichtsender 29 des entsprechenden Optokopplers 29 kurz geschlossen und deaktiviert dadurch den jeweiligen Leistungstransistor. Der Aufbau der Ansteuerelektroniken 25 in dieser Form hat zur Folge, dass bei geschlossenen zweiten Halbleiterschaltern 28 unabhängig von der Pulsweitenmodulation, also dem Schaltzustand des ersten Halbleiterschalters 27, stets ein elektrischer Strom durch die zweiten Halbleiterschalter 28 fließt.

Die zweiten Halbleiterschalter 28 sind im Falle des vorliegenden Ausführungsbeispiels vorgesehen, beispielsweise in einer Notsituation den Wechselrichter 22 automatisch auszuschalten, indem sie geöffnet werden. Dann liegen keine elektrischen Spannungen an den Optokopplern 26 an und die Leistungstransistoren 23 werden in ihren nicht-leitenden Zuständen (Sperrzustand) geschaltet.

Im Falle des vorliegenden Ausführungsbeispiels ist es vorgesehen, die zweiten Halbleiterschalter 28 bzw. die zweiten Transistoren 34 während des Normalbetriebs zu testen. Dieser Test kann vorzugsweise zyklisch durchgeführt werden.

Dieser Test wird folgendermaßen durchgeführt:
Während des Normalbetriebs wird der entsprechende zweite Halbleiterschalter 28 innerhalb der Zeitdauer geöffnet, in der aufgrund des Pulsmusters 38 der entsprechende Leistungstransistor 23 sperrt. Somit wird sicher gestellt, dass der Test den bestimmungsgemäßen Betrieb des Wechselrichters 22 während des Normalbetriebs nicht beeinträchtigt.

Um den entsprechenden zweiten Halbleiterschalter 28 zu überprüfen, wird zumindest während des Tests das am entsprechenden zweiten Halbleiterschalter 28 anliegende elektrische Signal überprüft bzw. ausgewertet. Dieses elektrische Signal ist beispielsweise die am entsprechenden Halbleiterschalter 28 anliegende elektrische Spannung, im Falle des zweiten Transistors 34 als zweiten Halbleiterschalter 28 die elektrische Spannung zwischen dessen Kollektor und dessen Emitter. Übersteigt z.B. der Betrag dieser elektrischen Spannung einen vorgegeben Wert bzw. entspricht zumindest in etwa der an der Ansteuerelektronik 25 anliegenden Versorgungsspannung, so hat der entsprechende zweite Halbleiterschalter 28 geöffnet bzw. sperrt der entsprechende zweite Transistor 34 zuverlässig. Somit kann davon ausgegangen werden, dass der getestete zweite Halbleiterschalter 28 in Ordnung ist. Ist dagegen der Betrag der am getesteten zweiten Halbleiterschalter 28 relativ klein, insbesondere zumindest annähernd Null, so öffnet der getestete zweite Halbleiterschalter 28 nicht bzw. sperrt der entsprechende zweite Transistor 24 nicht. Somit kann geschlossen werden, dass der getestete zweite Halbleiterschalter 28 schadhaft ist. Der Test wird insbesondere automatisch von der Steuervorrichtung 10 durchgeführt, welche z.B. mittels eines entsprechenden Rechenprogramms die zweiten Halbleiterschalter 28 ansteuert und die entsprechenden elektrischen Signale auswertet.

Wird ein schadhafter zweiter Halbleiterschalter 28 entdeckt, so kann z.B. die Steuervorrichtung 10 ein entsprechendes Warnsignal erzeugen.

Als elektrisches Signal zum Überprüfen des zweiten Halbleiterschalters 28 kann auch der elektrische Strom verwendet werden, welcher durch den getesteten zweiten Halbleiterschalter 28 fließt. Aufgrund der Parallelschaltung aus dem Optokoppler 26 und dem ersten Halbleiterschalter 27 fließt nämlich unabhängig vom Schaltzustand des ersten Halbleiterschalters 27 stets ein elektrischer Strom durch den zweiten Halbleiterschalter 28 solange dieser geschlossen ist. Folglich fließt auch während des Tests des zweiten Halbleiterschalters 27 ein nennenswerter elektrischer Strom, sollte der getestete zweite Halbleiterschalter 28 schadhaft sein und nicht öffnen. Somit kann aufgrund eines automatischen Auswertens dieses elektrischen Stroms insbesondere mittels der Steuervorrichtung 10 auf einen schadhaften zweiten Halbleiterschalter 28 geschlossen werden, indem z.B. der Betrag dieses elektrischen Stroms ausgewertet wird und auf einen schadhaften zweiten Halbleiterschalter 28 geschlossen wird, wenn während des Tests der Betrag des elektrischen Stroms größer als ein vorgegebener Mindestwert ist.

Im Falle des vorliegenden ist es vorgesehen, dass der Test der zweiten Halbleiterschalter 28 einen möglichst kleinen Zeitraum beansprucht. Dadurch kann erreicht werden, dass z.B. der Stellbereich des Verhältnisses der Pulsweitenmodulation für den Wechselrichter 22 nur geringen oder gar keinen Einschränkungen unterworfen ist. Durch eine geeignete Wahl von Kollektor- und Emitterwiderständen 36, 37 für die ersten Transistoren 27 und einer geeigneten Arbeitspunkteinstellung können die Schaltvorgänge der ersten und zweiten Transistoren 33, 34 beschleunigt werden. Dies ist deshalb möglich, weil die Schaltungstopologie in den Zweigen der ersten und zweiten Transistoren 33, 34 grundsätzlich einer Kaskodenschaltung entspricht. Die elektrische Spannung an der Basis des ersten Transistors 33 während einer logischen "1" im Verlauf des Signals der Pulsweitenmodulation für die ersten Transistoren 33 entspricht dabei der Basisgleichspannung einer üblichen Kaskodenschaltung.

Im Falle des vorliegenden Ausführungsbeispiels kann es noch vorgesehen sein, dass die zweiten Halbleiterschalter 28 auch verwendet werden, eine Sperrung oder Freigabe des Wechselrichters 22 zu anderen Zwecken umzusetzen. Beispielsweise kann es vorgesehen sein, dass das Signal zur Pulsweitenmodulation des Wechselrichters 22 von einem programmierbaren Baustein bereitgestellt wird, der eine gewisse Zeit zur Initialisierung benötigt und währenddessen noch keine definierten Steuersignale für die ersten Halbleiterschalter 27 bereitstellen kann. Eine Gefahr einer Fehlfunktion des Wechselrichters 22 kann zumindest verringert werden, wenn die zweiten Halbleiterschalter 28 in diesem Zeitraum im Sperrzustand gehalten werden bzw. geöffnet sind.

## Patentansprüche

1. Leistungselektronische Schaltung, aufweisend
- ein Leistungsteil (22) mit wenigstens einem Leistungshalbleiterschalter (23), das eingerichtet ist, aus einer elektrischen Spannung aufgrund eines abwechselnden Ein- und Ausschaltens des wenigstens einen Leistungshalbleiterschalters (23) eine getaktete elektrische Spannung für einen elektrischen Verbraucher (9) zu erzeugen, und
- eine Ansteuerelektronik (25), welche eingerichtet ist, den Leistungshalbleiterschalter (23) für das abwechselnde Ein- und Ausschalten anzusteuern, und welche einen Optokoppler (26) mit einer als Lichtsender (29) ausgebildeten Eingangsstufe und mit einem als Lichtempfänger (30) ausgebildeten Ausgangsstufe, einen parallel zum Lichtsender (29) geschalteten ersten Halbleiterschalter (27), und einen in Serie zur Parallelschaltung aus dem ersten Halbleiterschalter (27) und dem Lichtsender (29) geschalteten zweiten Halbleiterschalter (28) aufweist, wobei bei geöffnetem zweiten Halbleiterschalter (28) unabhängig vom Schaltzustand des ersten Halbleiterschalters (27) kein elektrischer Strom durch den Lichtsender (29) fließt und, wenn der zweite Halbleiterschalter (28) geschlossen ist, bei geöffnetem ersten Halbleiterschalter (27) ein elektrischer Strom durch den Lichtsender (29) fließt, und wobei der erste Halbleiterschalter (27) vorgesehen ist, gemäß einem Pulsmuster (38) abwechselnd geöffnet und geschlossen zu werden, sodass entsprechend dem Pulsmuster durch den Lichtsender (29) ein elektrischer Strom fließt und dadurch der Lichtsender (29) entsprechend dem Pulsmuster (38) Licht aussendet, welches der Lichtempfänger (30) empfängt, um ein entsprechendes Ansteuersignal (39) für den wenigstens einen Leistungshalbleiterschalter (23) zu erzeugen,
wobei die leistungselektronische Schaltung eingerichtet ist, während eines Normalbetriebs den ersten Halbleiterschalter (27) gemäß dem Pulsmuster (38) abwechselnd zu öffnen und zu schließen und den zweiten Halbleiterschalter (28) geschlossen zu lassen, und während eines Testbetriebs den ersten Halbleiterschalter (27) gemäß dem Pulsmuster (38) abwechselnd zu öffnen und zu schließen und den zweiten Halbleiterschalter (28) zu einem Zeitpunkt, an dem der erste Halbleiterschalter geschlossen ist und dadurch der wenigstens eine Leistungshalbleiterschalter (23) geöffnet ist, zu öffnen und wieder zu schließen, bevor der Leistungshalbleiterschalter (23) wieder geschlossen werden soll,
wobei die leistungselektronische Schaltung eingerichtet ist, während des Testbetriebs das am zweiten Halbleiterschalter (28) anliegende elektrische Signal auszuwerten, um zu überprüfen, dass der zweite Halbleiterschalter (28) zuverlässig öffnet.

2. Leistungselektronische Schaltung nach Anspruch 1, wobei das Leistungsteil als ein Wechselrichter (22), insbesondere als ein Wechselrichter (22) zum Erzeugen einer dreiphasigen Wechselspannung ausgebildet ist, und/oder wobei dem Pulsmuster (38) eine Pulsweitenmodulation zugrunde gelegt ist, und/oder der erste Halbleiterschalter (27) als ein erster Transistor (33) und/oder der zweite Halbleiterschalter (28) als ein zweiter Transistor (34) ausgebildet ist.

3. Elektrische Maschine, aufweisend eine leistungselektronische Schaltung nach einem der Ansprüche 1 bis 2, einen elektrischen Verbraucher (9), welcher mittels der leistungselektronischen Schaltung mit der getakteten elektrischen Spannung versorgt wird, und eine Steuervorrichtung (10), welche eingerichtet ist, den ersten Halbleiterschalter (27) gemäß dem Pulsmuster (38) durch Ansteuern zu öffnen und zu schließen.

4. Elektrische Maschine nach Anspruch 3, deren Steuervorrichtung (10) eingerichtet ist, während eines Normalbetriebs den ersten Halbleiterschalter (27) gemäß dem Pulsmuster (38) abwechselnd zu öffnen und zu schließen und den zweiten Halbleiterschalter (28) geschlossen zu lassen, und während eines Testbetriebs den ersten Halbleiterschalter (27) gemäß dem Pulsmuster (38) abwechselnd zu öffnen und zu schließen und den zweiten Halbleiterschalter (28) zu einem Zeitpunkt, in dem der wenigstens eine Leistungshalbleiterschalter (23) geöffnet ist, zu öffnen und wieder zu schließen, bevor der Leistungshalbleiterschalter (23) wieder geschlossen werden soll.

5. Elektrische Maschine nach Anspruch 4, deren Steuervorrichtung (10) eingerichtet ist, während des Testbetriebs das am zweiten Halbleiterschalter (28) anliegende elektrische Signal auszuwerten, um zu Überprüfen, ob der zweiten Halbleiterschalter (28) zuverlässig öffnet.

6. Elektrische Maschine nach einem der Ansprüche 3 bis 5, deren Steuervorrichtung (10) eingerichtet ist, während eines Initialisierens der leistungselektronischen Schaltung den zweiten Halbleiterschalter (28) geöffnet zu lassen.

7. Verfahren zum Testen der leistungselektronischen Schaltung nach Anspruch 1 oder 2, aufweisend folgende Verfahrensschritte:
- abwechselndes Öffnen und Schließen des ersten Halbleiterschalters (27) gemäß dem Pulsmuster (38), und
- Öffnen des zweiten Halbleiterschalters (28) so dass unabhängig vom Schaltzustand des ersten Halbleiterschalters (27) kein elektrischer Strom durch den Lichtsender (29) fließt, zu einem Zeitpunkt, an dem der erste Halbleiterschalter geschlossen ist und dadurch der wenigstens eine Leistungshalbleiterschalter (23) geöffnet ist, und wieder Schließen des zweiten Halbleiterschalters (28), bevor der Leistungshalbleiterschalter (23) wieder geschlossen werden soll.

8. Verfahren nach Anspruch 7, aufweisend Auswerten des elektrischen Signals, das zum Zeitpunkt des geöffneten zweiten Halbleiterschalters (28) an diesem anliegt, um zu überprüfen, ob der zweite Halbleiterschalter (28) zuverlässig öffnet.

## Claims

1. A power electronic circuit, comprising:
- a power component (22) comprising at least one power semiconductor switch (23) which power component (22) is arranged to generate, from an electrical voltage and on the basis of alternating switching on and off of the at least one power semiconductor switch (23), a clocked electrical voltage for a consumer of electrical energy (9), and
- electronic control circuitry (25) which is arranged to control the power semiconductor switch (23) for the alternating switching on and off, and which comprises an optocoupler (26) with an input stage which is constructed as a light transmitter (29) and with an output stage which is constructed as a light receiver (30), a first semiconductor switch (27) which is connected in parallel to the light transmitter (29), and a second semiconductor switch (28) which is connected in series to the parallel combination of the first semiconductor switch (27) and the light transmitter (29), wherein, when the second semiconductor switch (28) is open, electrical current does not flow through the light transmitter (29) irrespective of the switching state of the first semiconductor switch (27) and, when the second semiconductor switch (28) is closed, an electrical current flows through the light transmitter (29) when the first semiconductor switch (27) is open, and wherein the first semiconductor switch (27) is provided to be opened and closed, in an alternating fashion and according to a pulse pattern (38), so that an electrical current flows through the light emitter (29) in accordance with the pulse pattern and that, as a result of this, the light emitter (29) emits light in accordance with the pulse pattern (38), which the light receiver (30) receives in order to generate a corresponding control signal (39) for the at least one power semiconductor switch (23),
wherein, during a normal mode of operation, the power electronic circuit is arranged to open and close the first semiconductor switch (27) in an alternating fashion and in accordance with the pulse pattern (38), and to keep the second semiconductor switch (28) closed, and, during a test mode of operation, the power electronic circuit is arranged to open and close the first semiconductor switch (27) in an alternating fashion and in accordance with the pulse pattern (38), and to open the second semiconductor switch (28) at a point in time when the first semiconductor switch is closed and, as a result of this, the at least one power semiconductor switch (23) is open, and then to close the second semiconductor switch (28) again before the power semiconductor switch (23) is to be closed again,
wherein, during the test mode of operation, the power electronic circuit is arranged to evaluate the electrical signal which is present at the second semiconductor switch (28) in order to check that the second semiconductor switch (28) opens reliably.

2. The power electronic circuit according to claim 1, wherein the power component is constructed as an inverter (22), in particular as an inverter (22) for generating a three-phase alternating voltage, and/or wherein the pulse pattern (38) is based on a pulse width modulation, and/or wherein the first semiconductor switch (27) is constructed as a first transistor (33) and/or the second semiconductor switch (28) is constructed as a second transistor (34).

3. An electric machine comprising a power electronic circuit according to any one of the claims 1 to 2, a consumer of electrical energy (9) to which is supplied the clocked electrical voltage by means of the power electronic circuit, and a control device (10) which is arranged to open and close the first semiconductor switch (27) by controlling the latter in accordance with the pulse pattern (38).

4. The electric machine according to claim 3, wherein the control device (10) of which is arranged, during a normal mode of operation, to open and close the first semiconductor switch (27) in an alternating fashion and in accordance with the pulse pattern (38), and to keep the second semiconductor switch (28) closed, and, during a test mode of operation, the control device (10) is arranged to open and close the first semiconductor switch (27) in an alternating fashion and in accordance with the pulse pattern (38), and to open the second semiconductor switch (28) at a point in time when the at least one power semiconductor switch (23) is open, and then to close the second semiconductor switch (28) again before the power semiconductor switch (23) is to be closed again.

5. The electric machine according to claim 4, wherein the control device (10) of which is arranged to evaluate, during the test mode of operation, the electrical signal which is present at the second semiconductor switch (28) in order to check whether the second semiconductor switch (28) opens reliably.

6. The electric machine according to any one of the claims 3 to 5, wherein the control device (10) of which is arranged to keep the second semiconductor switch (28) open during an initialisation of the power electronic circuit.

7. A method of testing the power electronic circuit according to claim 1 or 2, comprising the following method steps:
- opening and closing the first semiconductor switch (27) in an alternating fashion and according to the pulse pattern (38), and
- opening the second semiconductor switch (28) so that, irrespective of the switching state of the first semiconductor switch (27), electrical current does not flow through the light emitter (29), at a point in time when the first semiconductor switch is closed and, as a result of this, the at least one power semiconductor switch (23) is open, and then closing the second semiconductor switch (28) again before the power semiconductor switch (23) is to be closed again.

8. The method according to claim 7, comprising evaluating the electrical signal which, at the point in time when the second semiconductor switch (28) is open, is present at the latter, in order to check whether the second semiconductor switch (28) opens reliably.

## Revendications

1. Circuit électronique de puissance, présentant
- une section de puissance (22) avec au moins un commutateur à semi-conducteurs de puissance (23), qui est conçue pour générer à partir d'une tension électrique en raison d'une mise sous tension et hors tension alternée de l'au moins un commutateur à semi-conducteurs de puissance (23) une tension électrique cadencée pour un consommateur électrique (9), et
- une électronique de commande (25) qui est conçue pour commander le commutateur à semi-conducteurs de puissance (23) pour la mise sous tension et hors tension alternée et qui présente un optocoupleur (26) avec un étage d'entrée réalisé en tant qu'émetteur de lumière (29) et avec un étage de sortie réalisé en tant que récepteur de lumière (30), un premier commutateur à semi-conducteurs (27) connecté en parallèle à l'émetteur de lumière (29), et un second commutateur à semi-conducteurs connecté en série au circuit parallèle à partir du premier commutateur à semi-conducteurs (27) et de l'émetteur de lumière (29), dans lequel lorsque le second commutateur à semi-conducteurs (28) est ouvert indépendamment de l'état de commutation du premier commutateur à semi-conducteurs (27) aucun courant électrique ne circule à travers l'émetteur de lumière (29), lorsque le second commutateur à semi-conducteurs (28) est fermé, lorsque le premier commutateur à semi-conducteurs (27) est ouvert un courant électrique circule à travers l'émetteur de lumière (29), et dans lequel le premier commutateur à semi-conducteurs (27) est prévu, conformément à un modèle d'impulsions (38) pour être ouvert et fermé en alternance, de sorte que, conformément au modèle d'impulsions à travers l'émetteur de lumière (29) un courant électrique circule et de ce fait l'émetteur de lumière (29) émet une lumière conformément au modèle d'impulsions (38), que reçoit le récepteur de lumière (30) pour générer un signal de commande (39) correspondant pour l'au moins un commutateur à semi-conducteurs de puissance (23),
dans lequel le circuit électronique de puissance est conçu pour, pendant un fonctionnement normal, ouvrir et fermer en alternance le premier commutateur à semi-conducteurs (27) conformément au modèle d'impulsions (38) et fermer le second commutateur à semi-conducteurs (28), et pendant un fonctionnement de test ouvrir et fermer en alternance le premier commutateur à semi-conducteurs (27) conformément au modèle d'impulsions (38) à un moment auquel le premier commutateur à semi-conducteurs est fermé et de ce fait l'au moins un commutateur à semi-conducteurs de puissance (23) est ouvert, pour s'ouvrir et se refermer avant que le commutateur à semi-conducteurs de puissance (23) doive être refermé,
dans lequel le circuit électronique de puissance est conçu pour, pendant le fonctionnement de test, évaluer le signal électrique qui est présent au niveau du second commutateur à semi-conducteurs (28), pour vérifier que le second commutateur à semi-conducteurs (28) s'ouvre de manière sûre.

2. Circuit électronique de puissance selon la revendication 1, dans lequel la section de puissance est réalisée en tant qu'onduleur (22), en particulier en tant qu'onduleur (22) pour la génération d'une tension alternative triphasée, et/ou dans lequel une modulation d'impulsions en largeur sert de base au modèle d'impulsions (38), et/ou le premier commutateur à semi-conducteurs (27) est réalisé en tant que premier transistor (33) et/ou le second commutateur à semi-conducteurs (28) est réalisé en tant que second transistor (34).

3. Machine électrique, présentant un circuit électronique de puissance selon l'une des revendications 1 à 2, un consommateur électrique (9) qui est alimenté au moyen du circuit électronique de puissance avec la tension électrique cadencée, et un dispositif de commande (10) qui est conçu pour ouvrir et pour fermer le premier commutateur à semi-conducteurs (27) conformément au modèle d'impulsions (38) par le biais d'une commande.

4. Machine électrique selon la revendication 3, dont le dispositif de commande (10) est conçu pour, pendant un fonctionnement normal, ouvrir et fermer en alternance le premier commutateur à semi-conducteurs (27) conformément au modèle d'impulsions (38) et fermer le second commutateur à semi-conducteurs (28), et pendant un fonctionnement de test ouvrir et fermer en alternance le premier commutateur à semi-conducteurs (27) conformément au modèle d'impulsions (38) et ouvrir et refermer le second commutateur à semi-conducteurs (28) à un moment où l'au moins un commutateur à semi-conducteurs de puissance (23) est ouvert avant que le commutateur à semi-conducteurs de puissance (23) doive être refermé.

5. Machine électrique selon la revendication 4, dont le dispositif de commande (10) est conçu pour, pendant le fonctionnement de test, évaluer le signal électrique se trouvant au niveau du second commutateur à semi-conducteurs (28), pour vérifier si le second commutateur à semi-conducteurs (28) s'ouvre de manière sûre.

6. Machine électrique selon l'une des revendications 3 à 5, dont le dispositif de commande (10) est conçu pour, pendant une initialisation du circuit électronique de puissance, ouvrir le second commutateur à semi-conducteurs (28).

7. Procédé pour le test du circuit électronique de puissance selon la revendication 1 ou 2, présentant les étapes de procédé suivantes :
- ouverture et fermeture en alternance du premier commutateur à semi-conducteurs (27) conformément au modèle d'impulsions (38), et
- ouverture du second commutateur à semi-conducteurs (28) de sorte que, indépendamment de l'état de commutation du premier commutateur à semi-conducteurs (27) aucun courant électrique ne circule à travers l'émetteur de lumière (29), à un moment où le premier commutateur à semi-conducteurs est fermé et de ce fait l'au moins un commutateur à semi-conducteurs de puissance (23) est ouvert, et à nouveau fermeture du second commutateur à semi-conducteurs (28) avant que le commutateur à semi-conducteurs de puissance (23) doive être refermé.

8. Procédé selon la revendication 7, présentant une évaluation du signal électrique qui est présent au niveau du second commutateur à semi-conducteurs (28) au moment où le second commutateur à semi-conducteurs (28) est ouvert pour vérifier si le second commutateur à semi-conducteurs (28) s'ouvre de manière sûre.
